# EUROPÄISCHE PATENTSCHRIFT

(11) **EP 2 027 399 B1**
(45) Veröffentlichungstag und Bekanntmachung des Hinweises auf die Patenterteilung: **24.10.2018**
(21) Anmeldenummer: 07703274.6
(22) Anmeldetag: 05.02.2007
(51) Int. Cl.: F16G 13/04, F16G 13/06, C23C 14/14

(54) **VERSCHLEISSFESTE KETTE MIT VERSCHLEISSSCHUTZBESCHICHTUNG IN NANOKRISTALLINER STRUKTUR**
WEAR-RESISTANT CHAIN WITH A WEAR-RESISTANT COATING HAVING A NANOCRYSTALLINE STRUCTURE
CHAÎNE ANTI-USURE AVEC REVÊTEMENT DE PROTECTION CONTRE L'USURE DANS UNE STRUCTRURE NANOCRISTALLIN

(30) Priorität: 24.05.2006 DE 102006024433
(43) Veröffentlichungstag der Anmeldung: 25.02.2009
(73) Patentinhaber: IWIS Motorsysteme GmbH & Co. KG, 81369 München (DE)
(72) Erfinder: WINKLHOFER, Johannes, 82131 Stockdorf (DE); WINKLHOFER, Gerhard, 82152 Krailling (DE); KOHN, Martin, 83714 Miesbach (DE); JÖRGENSEN, Gerald, 82256 Fürstenfeldbruck (DE); PINTOIU, Stefan, 81534 München (DE); KIRCHNER, Steffen, 83565 Tegernau (DE)
(74) Vertreter: Grünecker Patent- und Rechtsanwälte PartG mbB
(86) Internationale Anmeldenummer: PCT/EP2007/000964
(87) Internationale Veröffentlichungsnummer: WO 2007/134651

(56) Entgegenhaltungen:
- WO-A-2004/029321
- WO-A-2005/121047
- DE-A1- 10 118 763
- US-A1- 2003 177 752
- US-A1- 2003 195 074
- US-A1- 2005 188 942
- KUNTZ J D ET AL: "NANOCRYSTALLINE MATRIX CERAMIC COMPOSITES FOR IMPROVED FRACTURE TOUGHNESS" MRS BULLETIN, PITTSBURGH, US, Januar 2004 (2004-01), Seiten 22-27, XP008078761
- SCHIFFMANN K I ET AL: "Sizes and distances of metal clusters in Au-, Pt-, W- and Fe-containing diamond-like carbon hard coatings: a comparative study by small angle X-ray scattering, wide angle X-ray diffraction, transmission electron microscopy and scanning tunnelling microscopy", THIN SOLID FILMS, ELSEVIER-SEQUOIA S.A. LAUSANNE, CH, vol. 347, no. 1-2, 22 June 1999 (1999-06-22), pages 60-71, XP004363578, ISSN: 0040-6090, DOI: 10.1016/S0040-6090(98)01607-1
- VOEVODIN A A ET AL: "Superhard, functionally gradient, nanolayered and nanocomposite diamond-like carbon coatings for wear protection", DIAMOND AND RELATED MATERIALS, ELSEVIER SCIENCE PUBLISHERS, AMSTERDAM, NL, vol. 7, no. 2-5, 1 February 1998 (1998-02-01), pages 463-467, XP004115086, ISSN: 0925-9635, DOI: 10.1016/S0925-9635(97)00214-8
- HAUERT R: "An overview on the tribological behavior of diamond-like carbon in technical and medical applications", TRIBOLOGY INTERNATIONAL, BUTTERWORTH SCIENTIFIC LDT, GUILDFORD, GB, vol. 37, no. 11-12, 1 November 2004 (2004-11-01), pages 991-1003, XP004614320, ISSN: 0301-679X, DOI: 10.1016/J.TRIBOINT.2004.07.017
- VOEVODIN A A ET AL: "Recent Advances in Hard, Tough, and Low Friction Nanocomposite Coatings", TSINGHUA SCIENCE AND TECHNOLOGY, TSINGHUA UNIVERSITY PRESS, BEIJING, CN, vol. 10, no. 6, 1 December 2005 (2005-12-01), pages 665-679, XP022932940, ISSN: 1007-0214, DOI: 10.1016/S1007-0214(05)70135-8 [retrieved on 2005-12-01]

## Beschreibung

Die vorliegende Erfindung betrifft eine verschleißfeste Kette mit jeweils mittels eines Kettengelenks miteinander verbundenen Kettengliedern.

Eine solche Kette ist z.B. aus der DE 10311915 A1 bekannt. Insbesondere die dem Verschleiß ausgesetzten Oberflächenbereiche der dort beschriebenen Kettenkonstruktionen werden mittels einer diamantartigen amorphen Kohlenstoffschicht (DLC) beschichtet. Hierbei handelt es sich je nach Kettentyp um die Gelenkflächen und/oder die mit einem Kettenrad in Kontakt tretenden Flächen. Die DLC-Schicht wird demnach hauptsächlich dort angewendet, wo Bauteile oder Bauelemente miteinander in Berührung treten. Der diamantartige amorphe Kohlenstoff (DLC) ergibt einen Kohlenstoffbeschichtungsfilm, der Eigenschaften aufweist, die einem Diamanten angenähert sind. Der Vorteil einer derartigen Beschichtung liegt demnach darin, möglichst dünne Schichen aufzubringen, die einen gewünschten verbesserten Verschleißschutz bieten. Zusätzlich können metallische Partikel aus Wolfram, Chrom oder Titan in die DLC-Schicht dispergiert sein.

Des Weiteren beschreiben die DE 20 2004001984 U1 eine Rollenkette, bei der die Kettenbolzen ebenfalls mit einer DLC-Schicht versehen sein können, während die zugehörigen Buchsen der Innenkettenglieder zumindest an ihrer inneren Oberfläche boriert sind.

Sämtliche Maßnahmen tragen bereits zu einer wesentlichen Verbesserung des Verschleißes bei und ermöglichen, Ketten herzustellen, die auch unter extremen Einsatzbedingungen, wie sie insbesondere im Kfz-Bereich, z.B. für einen Steuerkettentrieb, erforderlich sind, Verwendung finden können. Gerade im Kfz-Bereich spielen Downsizing-Vorgaben eine entscheidende Rolle, weshalb dem Verschleißschutz große Bedeutung zukommt.

Der vorliegenden Erfindung liegt daher die Aufgabe zugrunde, eine verschleißfeste Kette der eingangs genannten Art bereitzustellen, die hinsichtlich ihrer Verschleißfestigkeit nochmals verbessert ist.

Diese Aufgabe wird bei einer verschleißfesten Kette gemäß dem Oberbegriff von Anspruch 1 dadurch gelöst, dass zumindest ein einem Reibverschleiß ausgesetzter Oberflächenbereich der Kettengelenke und/oder der Kettenglieder mit einer Verschleißschutzbeschichtung mit zumindest zum Teil nanokristalliner Struktur versehen ist, dass Nanokristalle der Verschleißschutzbeschichtung einen Durchmesser von ≤ 100 nm, bevorzugt ≤ 50 nm, aufweisen und dass die Verschleißschutzbeschichtung eine amorphe Matrix umfasst, in der die Nanokristalle eingebettet sind und wobei der Matrixanteil ≤ 10 Vol.-% beträgt.

Bei der Erfindung geht es demnach nicht speziell um Nanolayer, die durch die Schichtdicke im Nanobereich gekennzeichnet sind, sondern um nanokristalline bzw. teilweise nanokristalline Verschleißschutzbeschichtungen. Maßgebend ist demnach die Größe der kristallinen Partikel, die in der Verschleißschutzbeschichtung eingelagert sind. Die Schichten selbst können mehrere Mikrometer dick sein. Partikel in nanokristalliner Form weisen weniger oder gar keine Kristalldefekte auf, die sich bei der Herstellung größerer Partikel nicht vermeiden lassen. Die messbare Härte kristalliner Hartstoffe liegt nämlich meist deutlich unter ihrer theoretischen Härte, die man aus den Bindungskräften berechnen kann. Ursache hierfür sind diese oben genannten Kristalldefekte. Reduziert man aber die Größe von den Partikeln auf wenige Nanometer so können die Defekte unwirksam werden. Durch diese Eigenschaft der nanokristallinen Partikel lässt sich deren Härte sehr stark heraufsetzen, wodurch sich eine sehr harte Verschleißschutzbeschichtung erzeugen lässt.

Erfindungsgemäß weisen die Nanokristalle der Verschleißschutzbeschichtung einen Durchmesser von ≤ 100 nm, bevorzugt ≤ 50 nm, auf. Üblicherweise sind die Nanokristalle von unregelmäßiger Struktur. Mit Durchmesser ist deshalb der theoretische Durchmesser der kleinsten ein Nanokristall aufnehmenden Kugel gemeint. Zum Teil können die Größen auch deutlich unterhalb von 50 nm oder sogar 20 nm, z.B. 5 - 10 nm liegen. Der hier angegebene Durchmesser ist der Durchmesser des statistischen Mittels aller Nanokristalle in der nanokristallinen Struktur der Verschleißbeschichtung.

Erfindungsgemäß umfasst die Verschleißschutzbeschichtung eine amorphe Matrix in der die Nanokristalle eingebettet sind. Hierdurch wird eine Rissausbreitung behindert, da die Nanokristalle in aller Regel eher spröde sind und die amorphe Matrix diesbezüglich entgegenwirkt. Erfindungsgemäß ist der Matrixanteil sehr klein gehalten (wenige Volumen-Prozent, ≤ 10%), damit die Nanokristalle ihre Verschleißschutzwirkung am Besten entfalten. Bei einer weiteren Ausführungsform umfasst die Verschleißschutzbeschichtung ta-C (tetraedrisch gebundener amorpher Kohlenstoff). Es handelt sich demnach um eine Kohlenstoffbeschichtung, die mittels eines gepulsten Vakuumbogen-Kohlenstoff-Plasmas durch Laser Arc Deposition (PVD) aufgebracht wurde. Hierbei bildet sich eine amorphe Grundstruktur aus, in der Partikel aus Kohlenstoff in sp³-Bindung (wie Diamant) eingelagert sind. Hierdurch unterscheidet sich diese Verschleißschutzbeschichtung von klassischen DLC- oder a-C:H-, Me-C:H- Beschichtungen, die überwiegend sp²-gebunden sind.

Bevorzugt weist eine solche Verschleißschutzbeschichtung eine Härte im Bereich von 4000 - 7500 HV auf. Klassische Kohlenstoffbeschichtungen erreichten bislang in der Regel um ca. 2000 HV. Zum Vergleich sei die Härte von Diamant genannt, die ca. 8000 HV beträgt.

Der Vorteil einer solchen Verschleißschutzbeschichtung liegt auch in dem extrem niedrigen Reibbeiwert, der insbesondere bei Wasser erstaunliche 0,047 beträgt und bei Öl sich bei ca. 0,082 bewegt. Dies ist deutlich besser als bei herkömmlichen DLC-Beschichtungen, da kein Wasserstoffanteil in der Beschichtung eingelagert wird. Hierdurch eignet sich eine solche Verschleißschutzbeschichtung besonders für Anwendung bei Mangelschmierung und Notlauf. Die beschichteten Oberflächenbereiche sind daher besonders verschleißfest in Wälz-/Gleitkontakten und sogar verschleißfester als WC/Co-, WC-CoCr und a-C:H, denen sie somit überlegen sind.

Günstigerweise wird eine solche Verschleißschutzbeschichtung mit einer Schichtdicke von maximal 10 µm aufgebracht, da bis zu einer solchen Schichtdicke eine große Haftfestigkeit gegeben ist.

Gemäß einer weiteren Ausführungsform kann die Verschleißschutzbeschichtung eine Haftschicht mit Me-C:H oder CrN und eine Deckschicht mit DLC und Nanokristallen aus Si und/oder SiC oder eine Deckschicht mit DLC und Nanokristallen aus B und/oder BC umfassen. Der Auftrag derartiger Schichten erfolgt durch PA-CVD-Verfahren bei einer Beschichtungstemperatur von unterhalb 180°C. Hierdurch ergeben sich keine werkstofftechnischen Auswirkungen auf das Basismaterial der Kettenteile, falls diese vorher wärmetechnisch behandelt wurden. Je glatter die Grenzfläche zwischen der Deckschicht und der Haftschicht ausfällt, um so härter ist die Verschleißschutzbeschichtung. Die Härte von herkömmlichen DLC-Schichten kann im Wesentlichen beibehalten werden (in der Regel ungefähr 2000 HV), wohingegen sich die Verschleißfestigkeit erhöht.

Günstigerweise bewegt sich demnach die Härte einer solchen Verschleißschutzbeschichtung im Bereich von 1600 - 2100 HV.

Des Weiteren kann die Haftschicht maximal 1,5 µm und die Deckschicht ebenfalls maximal 1,5 µm dick sein. Die Kombination von Haftschicht und Deckschicht sorgt für eine gute Anbindung an den Grundwerkstoff und für eine haftfeste Verschleißschutzbeschichtung.

Gemäß einer weiteren Variante kann die Verschleißschutzbeschichtung eine Matrix mit Si₃N₄ oder Bornitrid umfassen, wobei die Nanokristalle TiN und/oder AIN enthalten. Eine solche nitridische Nano-Beschichtung wird mittels eines Arc-PVD-Verfahrens (LARC®) aufgebracht. Bei dieser Schicht umlagert amorphes Siliziumnitrid als zweite Phase die Nitrid-Körner in Verbindung als Si₃N₄, alternativ Bornitrid. Hierdurch entsteht in diesem Bereich eine nanokristalline Struktur und ein sogenannter "nasser Sand"- oder "Waben"-Effekt, wodurch Risse aufgefangen werden (sehr gute Rissausbreitungshemmung). Des Weiteren kann durch dieses Verfahren eine Steigerung des Aluminiumanteils über die sonst kritische Grenze von ca. 70 % hinweg erreicht werden, ab der normalerweise ein Einbruch der mechanischen Eigenschaften der Schicht zu verzeichnen ist. Dadurch lässt sich auch eine um bis zu 300°C gesteigerte Warmfestigkeit auf bis > 1200°C erreichen, ohne dass spinodale Zerlegungsprozesse nennenswert auftreten. Hierbei beträgt der Siliziumanteil bis > 10 %. Die intrinsischen Eigenspannungen werden durch die Nanokristallinität auch bei sehr hoher Schichtstärke in akzeptablen Grenzen gehalten (- 3 bis -4 Gpa). Derartige Schichten ermöglichen durch die Si-Anteile und die Nano-Kristallstruktur eine verbesserte Korrosionseigenschaft.

Bevorzugt weist eine derartige Verschleißschutzbeschichtung eine Härte im Bereich von 30 - 45 GPa auf.

Die Schichtdicke der Verschleißschutzbeschichtung kann hierbei sich im Bereich von 1 bis 4 µm bewegen.

Gemäß einer weiteren Ausführungsform kann die Verschleißschutzbeschichtung eine Matrix mit Si₃N₄ und Nanokristalle aus TiN und/oder SiN enthalten. Hierbei handelt es sich ebenfalls um eine nitridische Nano-Beschichtung, die durch reaktives DC- oder HF-Magnetronsputtern aufgebracht wurde. Hierdurch entstehen kolumnare bis nanokristalline TiN-Körner, eingebettet in einer amorphen Si₃N₄-Matrix. Hierdurch wird eine Kombination von hoher Härte mit hoher Bruchzähigkeit erreicht. Diese Verschleißschutzbeschichtung ist insbesondere für tribologische Anwendungen interessant, da über den Siliziumgehalt und die Abscheidebedingung Härte, Gefüge, Korngröße und Bruchzähigkeit in weiten Bereichen eingestellt werden kann.

Bevorzugt bewegt sich die Härte dieser Verschleißschutzbeschichtung im Bereich von 30 - 45 GPa.

Günstigerweise kann die Schichtdicke einer derartigen Verschleißschutzbeschichtung sich im Bereich von 2 bis 4 µm bewegen.

Bei einer weiteren Ausführungsform ist vorgesehen, dass die Verschleißschutzbeschichtung eine Metallmatrix umfasst. In Abhängigkeit von dem gewählten Metall bringt die Matrix bereits gewünschte Materialeigenschaften mit sich, die bestens bekannt sind.

Gemäß einer Variante kann die Metallmatrix Kupfer und/oder Wolfram und/oder Zink und/oder Zinn umfassen.

Hierbei ist es besonders günstig, wenn die Nanokristalle Zirkonnitrit und/oder Al₂O₃ und/oder Si₃N₄ und/oder TiO₂ umfassen, die dann in der Metallmatrix dispergiert sind. Die Herstellung solcher Schichten erfolgt z.B. mittels Gasflusssputtern (GFS), einem PVD-Verfahren mit einem gasstromgeführten Materialtransport.

Gemäß einer weiteren Ausführungsform ist vorgesehen, dass die Verschleißschutzbeschichtung BN und/oder B₄C und/oder VN umfasst. Diese Materialien sind alle als Hartstoffe bekannt, die bei entsprechend nanokristalliner Einbringung in die Verschleißschutzbeschichtung die gewünschte Verbesserung der Verschleißfestigkeit herbeiführen. Zum Teil ergibt sich auch eine Mischung aus amorphen und nanokristallinen Strukturen. dieser Werkstoffe.

Des Weiteren kann die Verschleißschutzbeschichtung Nitridkeramikbildner und/oder Oxidkeramikbildner umfassen. Auch hier können unterschiedliche Matrixmaterialien verwendet werden. Es ist jedoch auch möglich, dass die Matrix aus den gleichen Nitridkeramikbildnern und/oder Oxidkeramikbildnern besteht, in denen die Nanokristalle eingelagert sind.

Bevorzugt ist die Verschleißschutzbeschichtung mittels eines CVD-Verfahrens hergestellt. Mit solchen CVD-Verfahren können trotz niedriger Prozesstemperaturen verschleißbeständige DLC-Schichten hergestellt werden, ohne dass sich eine Beeinträchtigung des Grundwerkstoffes ergibt. Insbesondere können dabei plasmaaktivierte CVD-Verfahren (PE-CVD) zum Einsatz kommen.

Als Alternative kann die Verschleißschutzbeschichtung aber auch mittels eines PVD-Verfahrens hergestellt sein. Auch hier gibt es Verfahrensvarianten, die mit niedrigen Prozesshöhungstemperaturen, z.B. < 150°C eine Aufbringung der Verschleißschutzbeschichtung ermöglichen.

Um die gewünschte Erhöhung der Verschleißfestigkeit von Ketten zu erzielen, können die Kettengelenke ein Innen- und ein Außenelement umfassen, wobei zumindest bereichsweise die Gelenkoberflächen der Innen- und/oder Außenelemente mit einer Verschleißschutzbeschichtung versehen sind oder ist. Die Gelenke der Kette sind besonderem Verschleiß ausgesetzt, da hier die Kraftübertragung zwischen den Kettengliedern bei gleichzeitiger Bereitstellung einer Relativbewegung zwischen diesen erfolgt.

Bei einer weiteren Variante weisen die Kettenglieder Zahnlaschen auf, wobei zumindet bereichsweise die in Eingriff mit einem Kettenrad kommenden Zahnflanken mit einer Verschleißschutzbeschichtung versehen sind. In diesem Zusammenhang sei auch erwähnt, dass die Eingriffsflanken der Kettenräder eine der hier beschriebenen Beschichtungen aufweisen können.

Gemäß einer weiteren Ausgestaltung wechseln sich Außen- und Innenkettenglieder einander ab und sind mittels jeweils eines Kettengelenks miteinander verbunden, wobei die Außenkettenglieder Außenlaschen und Kettenbolzen umfassen und die Innenkettenglieder Innenlaschen, Kettenhülsen und Rollen umfassen, wobei zumindest teilweise die in Wirkkontakt miteinander stehenden Oberflächenbereiche der Außenlaschen und/oder der Kettenbolzen und/oder der Innenlaschen und/oder der Kettenhülsen und/oder der Rollen mit einer Verschleißschutzbeschichtung versehen sind.

Es besteht aber auch die Möglichkeit, dass das Kettengelenk ein Wiegegelenk mit Wiegestiften ist. Bei einer solchen Variante sind zumindest die in Wirkkontakt stehenden Wiegeflächen der Wiegestifte wenigstens bereichsweise mit einer Verschleißschutzbeschichtung versehen.

Bei den hier verwendeten Verschleißschutzbeschichtungen handelt es sich vorwiegend um sogenannte Nanokomposite. Unter Kompositen versteht man Werkstoffe, die aus mindestens zwei unterschiedlichen Stoffen (Phasen) bestehen, welche nicht auf atomarer Ebene vermischt sind oder miteinander eine chemische Verbindung bilden. Eine häufige Form von Kompositen sind Teilchen des einen Stoffes, die in dem anderen Stoff (Matrix) gleichmäßig verteilt sind. Bei den meisten der hier beschriebenen Verschleißschutzbeschichtungen beträgt der Anteil der Nanokristalle über 50 Volumen-Prozent, bevorzugt über 80 Volumen-Prozent.

Im Folgenden werden Ausführungsbeispiele der vorliegenden Erfindung anhand einer Zeichnung näher erläutert. Es zeigen:
- Fig. 1: eine Explosionsdarstellung einer Rollenkette,
- Fig. 2: die Rollenkette aus Fig. 1 in einem vergrößerten Vollschnitt,
- Fig. 3: eine Zahnkette in perspektivischer, teilweise geschnittener Darstellung,
- Fig. 4: eine schematische Darstellung einer Zahnlasche der Kette aus Fig. 3 und
- Fig. 5: eine schematische Darstellung einer weiteren Ausführungsform einer Zahnkette in Seitenansicht.

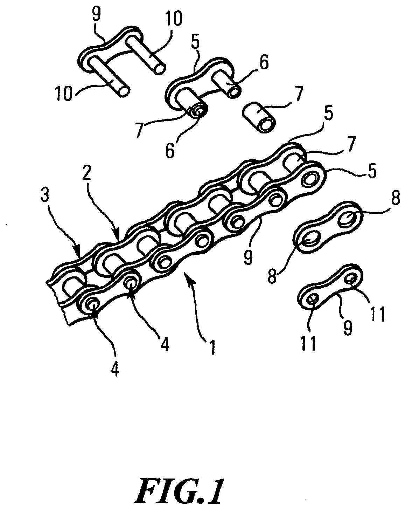

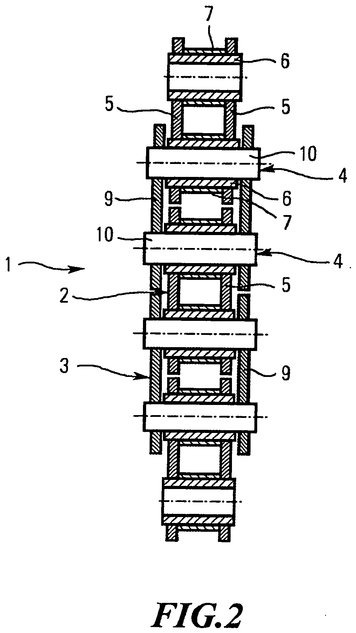

In Fig. 1 und 2 ist eine Rollenkette 1 mit sich einander abwechselnden Innenkettengliedern 2 und Außenkettengliedern 3 dargestellt. Die Innenkettenglieder 2 und Außenkettengleider 3 sind jeweils mittels eines Kettengelenks 4 gelenkig miteinander verbunden.

Das Innenkettenglied 2 umfasst zwei parallel zueinander angeordnete Innenlaschen 5, zwei parallele, die Innenlaschen 5 miteinander verbindende Gelenkhülsen 6 und zwei drehbar auf den Gelenkhülsen 6 angeordnete Rollen 7. Die Endabschnitte der Gelenkhülsen 6 sind in die zugehörigen Öffnungen 8 der Innenlaschen 5 eingepresst.

Die Außenkettenglieder 3 umfassen zwei im parallelen Abstand zueinander angeordnete Außenlaschen 9 und zwei diese miteinander verbindende, parallel zueinander angeordnete Kettenbolzen 10.

Jeweils ein Kettenbolzen 10 eines Außenkettengliedes 3 erstreckt sich durch eine Gelenkhülse 6 eines Innenkettengliedes 2 zum Ausbilden eines Kettengelenks 4.

Im vorliegenden Fall bestehen sämtliche Kettenbestandteile aus einem Stahlwerkstoff. Die Kettenbolzen 10 bestehen z.B. aus einem 100Cr6 und die Laschen 5 und 9 aus 42CrMo4.

Auf mögliche Verschleißschutzbeschichtungen wird weiter unten noch näher eingegangen. Neben der vollflächigen Aufbringung von Verschleißschutzschichten auf sämtliche Kettenbestandteile, wird vorrangig eine Verschleißschutzbeschichtung auf die Außen- und Innenflächen der Rollen 7, die Außen- und Innenflächen der Gelenkhülsen 6 und die Außenflächen der Kettenbolzen 10 aufgebracht. Hierbei besteht die Möglichkeit, dass je nach Bedarf eine einzelne oder eine Kombination einzelner oder sämtlicher der genannten Flächen oder Bereiche dieser Flächen zur Aufbringung einer Verschleißschutzbeschichtung herangezogen werden. Darüber hinaus können auch die Stirnflächen der Gelenkhülsen 6, der Rollen 7 und die zugeordneten Innenflächen der Innenlaschen 5 und/oder der Außenlaschen 9 mit einer Verschleißschutzbeschichtung versehen sein.

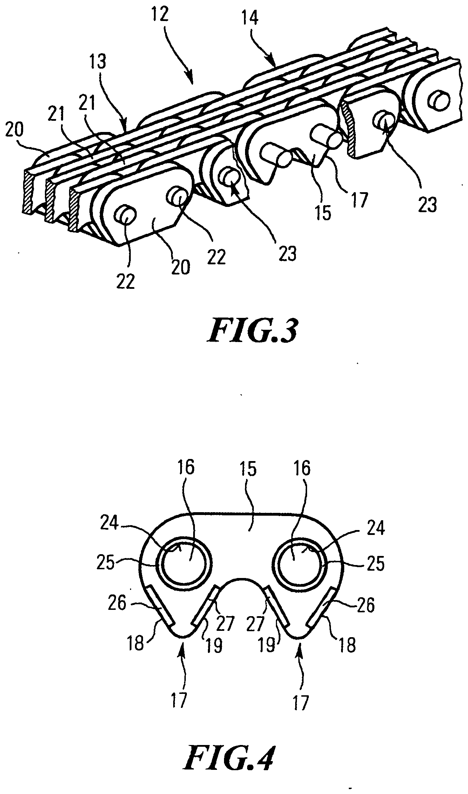

Anhand er Fig. 3 und 4 wird nunmehr ein anderer Kettentyp näher erläutert.

Bei der in Fig. 3 dargestellten Kette handelt es sich um eine Zahnkette 12, die sich aus einander abwechselnden Innenkettengliedern 13 und Außenkettengliedem 14 zusammensetzt.

Jedes Innenkettenglied 13 umfasst drei im parallelen Abstand zueinander angeordnete Zahnlaschen 15, wie in Fig. 4 dargestellt. Jede Zahnlasche 15 weist zwei im Abstand zueinander angeordnete Gelenköffnungen 16 auf und zwei im Abstand zueinander angeordnete Zähne 17 mit Außenflanken 18 und Innenflanken 19 auf.

Jedes Außenkettenglied 14 umfasst zwei außen liegende, nicht verzahnte Führungslaschen 20 und zwei im Abstand zueinander innen liegende Zahnlaschen 21, sowie die Laschen 20 und 21 miteinander verbindende Kettenbolzen 22. Die Laschen 20 und 21 der Außenkettenglieder 14 sind auf die Kettenbolzen 22 aufgepresst, wobei die Laschen 20 und 21 jeweils durch die Zahnlaschen 15 der Innenkettenglieder 13 voneinander getrennt sind. Die Zahnlaschen 15 der Innenkettenglieder 13 sitzen mit Spiel auf den Kettenbolzen 22 zum Ausbilden eines Kettengelenks 23.

In der Fig. 4 ist angedeutet, dass die Innenfläche 24 der Gelenköffnungen 16 mit einer Verschleißschutzbeschichtung 25 und die Außenflanken 18 und Innenflanken 19 mit Verschleißschutzbeschichtungen 26 bzw. 27 versehen sind.

Auf den genauen Aufbau der Verschleißschutzbeschichtungen 25 bis 26 wird im Folgenden weiter unten noch näher eingegangen. Die oben anhand der Fig. 3 und 4 beschriebene Zahnkette 12 soll nur als Konstruktionsbeispiel verstanden sein. Im Stand der Technik existieren eine Vielzahl unterschiedlicher Konstruktionsvarianten (z.B. blockweise Anordnung von Zahnlaschen, Anwendung von Random-Prinzipien, Verwendung von Gelenkhülsen etc.). Die vorliegende Erfindung soll auf alle diese Konstruktionsvarianten anwendbar sein.

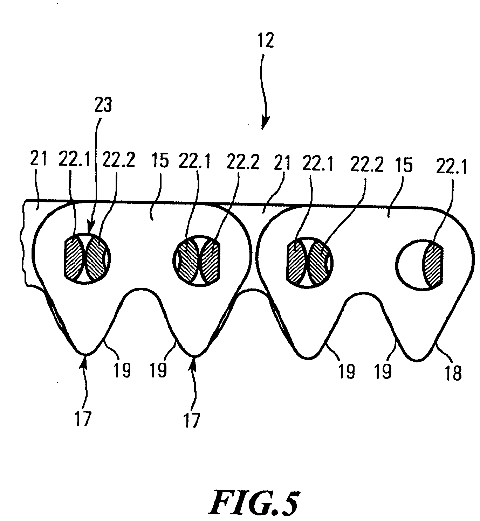

Anhand der Fig. 5 ist eine weitere Konstruktionsvariante einer Zahnkette 12 näher beschrieben. Es soll im Folgenden nur auf die wesentlichen Unterscheide eingegangen werden, weshalb auf gleiche und wirkungsgleiche Elemente mit gleichen Bezugsziffern Bezug genommen und auf die obige Beschreibung verwiesen wird.

Der wesentliche Unterschied besteht darin, dass als Kettengelenk 23 ein Wiegegelenk, bestehend aus dem Wiegebolzen 22.1 und 22.2 verwendet wird. Die gewölbten Seiten der Wiegebolzen 22.1 und 22.2 wälzen sich aufeinander ab und bilden so das Kettengelenk 23. Zumindest die gewölbten aufeinander abrollenden Oberflächen der Wiegebolzen 22.1 und 22.2 sind mit einer unten noch näher zu beschreibenden Verschleißschutzbeschichtung versehen. Im Folgenden werden Ausführungsbeispiele der bei den oben beschriebenen Ketten verwendbaren Verschleißschutzbeschichtungen näher beschrieben:

### I. ta-C tetraedrisch gebundener amorpher Kohlenstoff

### Familie:

### Amorphe Kohlenstoffschichten

### Verfahren:

- Laser Arc Depostion (PVD), gepulstes Vakuumbogen-Kohlenstoff-Plasma. Einziges Verfahren für eine sehr genaue Pulseinstellung bei hohen Pulsfrequenzen des Lichtbogens. Verfahren ohne Wasserstoffbeteiligung.
- Andere Verfahren zur Herstellung amorpher C-Schichten sind sonst
   CVD, wobei C über die Gasphase zugeführt wird unter Anwesenheit von Wasserstoff. Dabei wird mindestens 15 % Wasserstoff eingelagert, was die Härte herabsetzt und den Reibbeiwert steigert.
   Sputtern, wobei gesputterte C-Schichten relativ weich sind und geringe Abscheideraten haben.
- Beschichtungstemperatur < 150°C möglich
- ggf. Nachpolitur auf 0,26 Rz und 0.03 Ra.

### Eigenschaften:

- amorphe bis nanokristalline Schichtstruktur
- sp³-Bindung der Nanokristalle (wie Diamant und anders als klassische DLC oder a-C:H, Me-C:H, die überwiegend sp₂-gebunden sind)
- Härte 4000 - 7500 HV, anders als andere C-Schichten, die in der Regel -2000 HV aufweisen. Diamant ca. 8000 HV
- haftfest bis 10 µm Schichtdicke
- extrem niedriger Reibbeiwert in Wasser von 0.047, in Öl von 0,082. Dies ist deutlich besser als bei DLC, da kein Wasserstoffanteil in der Schicht.
- besonders geeignet für Anwendung bei Mangelschmierung und Notlauf
- besonders verschleißfest in Wälz-/Gleitkontakten und verschleißfester als WC-Co, WC-CoCr und a-C:H.

### II. DLC, Si-dotiert:

### Familie:

### Amorphe Kohlenstoffschichten

### Verfahren:

- PA-CVD
- Beschichtungstemperatur < 180°C möglich

### Eigenschaften:

- Typisch Me-C:H Haftschicht 1 µm dick, alternativ CrN möglich
- Deckschicht typischerweise 1 µm dich (DLC + Si)
- Si-Einlagerung in Verbindung als SiC, Alternativ Borcarbid, dadurch nanokristalline Struktur in diesem Bereich.
- Härte 1600 - 1800 HV bei rauer Grenzfläche zwischen den einzelnen Zwischenschichten. Kein Härteverlust gegenüber anderen DLC-Schichten, die in der Regel -2000 HV aufweisen, wenn prozesstechnisch glatte Zwischenflächen erreicht sind.

### III. nACo® (nc-AlTiN)/(a-Si₃N₄):

### Familie:

### Nitridische Nano-Beschichtungen

### Verfahren:

- Arc-PVD bzw. LARC® (Platit)
- Beschichtungstemperatur 400 - 470°C
- Zur Erreichung glatter Zwischenflächen und hoher Härten ist eine enge Anordnung der verschiedenen Kathoden beieinander erforderlich.
- Si aus Gasphase (Silan..) oder vom Target (dann ohne Wasserstoffproblem)

### Eigenschaften:

- Schichtdicken 1 - 4 µm
- Härtesteigerung und Rissausbreitungshemmung. Amorphes Siliziiumnitrid umlagert als zweite Phase die Nitrid-Körner in Verbindung als Si₃N₄, alternativ Bornitrid, dadurch nanokristalline Struktur in diesem Bereich und ein "nasser-Sand" oder "Waben"-Effekt. Risse werden aufgefangen.
- Si-Anteil bis > 10 %
- Steigerung des Aluminium-Anteils über die sonst kritische Grenze von -70 % hinweg, ab der normalerweise ein Einbruch der mechanischen Eigenschaften der Schicht zu verzeichnen ist. Dadurch auch eine um bis zu 300°C gesteigerte Warmfestigkeit auf bis > 1200°C, ohne dass spinodale Zerlegungsprozesse nennenswert auftreten.
- Die intrinsischen Eigenspannungen werden durch die Nano-Kristallinität auch bei sehr hoher Schichtstärke in akzeptablen Grenzen gehalten (-3 bis -4 GPa).
- Verbesserte Korrosionseigenschaften durch Si-anteile und Nano-Kristallstruktur
- Härte 45 GPa

### IV. Si-dotierte TiN-Schichten (nc-TiSiN)

### Familie

### Nitridische Nano-Beschichtung

### Verfahren:

- Reaktives DC- oder HFV-Magnetronsputtern
- Abscheidetemperaturen (150 bis 450°C
- Biasspannung (0 bis -400 V)
- Doppelkathodenverfahren mit einem Ti- und Si-Target
- Alternativ auch Lichtbogenverfahren möglich

### Eigenschaften

- Schichtdicke: typisch 2 - 4 µm
- Gefüge: Kolumnare bis nanokristalline TiN-Körner, eingebettet in einer amorphen Si₃N₄-Matrix
- Dadurch Kombination von hoher Härte mit hoher Bruchzähigkeit
- Absolutwerte und Verhältnis von Härte zu Bruchzähigkeit kann kontinuierlich über den Si-Gehalt eingestellt werden.
- Maximale Härte 45 GPa biw 2 bis 5 at-% Si
- Starke TiN-Kornfeinung mit zunehmenden Si-Gehalt (Korngröße ca. 6nm)
- Übergang von kolumnarer TiN-Schichtstruktur (Si < 1 at-%) zu äquiaxialen, nanokristallinen TiN-Körner (Si > 6 at-%)
- Druckeigenschaften (4 -6 GPa)
- Für tribologische Anwendung interessant, da über den Si-Gehalt und die Abscheidebedingung Härte, Gefüge, Korngröße und Bruchzähigkeit in weiten Bereichen eingestellt werden kann.

### V. Oxidkeramikbildner

Als Matrix wurden verschiedene Metalle verwendet, vor allem Kupfer, neben Wolfram, Zink und Zinn.

Die Herstellung der Schichten erfolgt mittels Gasflusssputtern (GFS), einem PVD-Verfahren, das auf einer Hohlkathodenglimmentladung und einem gasstromgeführten Materialtransport beruht. Aufgrund des Arbeitsdruckes (ca. 0,5 mbar) und des spezifischen Transportmechanismus können mittels GFS bereits in der Gasphase nichtagglomerierte Nanopartikel hergestellt werden. Die Schichtabscheidung erfolgt teilweise mit zwei unabhängigen Quellen für Partikel und Matrix (Co-Deposition), teils aus einer Quelle mit einem zusammengesetzten Target.

Die härtesten Oxidschichten wurden auf der Basis von TiO₂ hergestellt. Bei einer Kombination mit Kupfer hat sich erstaunlicherweise herausgestellt, dass sich das Kupfer nicht in den Partikelzwischenräumen anlagert, sondern als kristalline Säulen ausscheidet. Das entstehende Nanokomposit wird dagegen primär durch kristallines TiO₂ in Rutil-Struktur und durch amorphes TiO₂ als Matrix gebildet. Schichten dieser Struktur, auch ohne Kupfer, zeigten Härten bis 25 GPa, was die Härte gewöhnlicher Titandioxidschichten deutlich übersteigt (11 - 15 GPa).

Die oben genannten Aufbauten der Verschleißschutzbeschichtungen sollen als Beispiele verstanden sein, solange verschleißverbessernde nanokristalline Partikel in einer amorphen Matrix eingebettet werden. Bei den oben gewählten Abkürzungen bedeutet nc - nanokristallin und a - amorph. Zu den Nanokompositen gehören insbesondere nc-TiN/a-Si₃N₄, nc-TiN/a-TiSi₂/a-Si₃N₄, nc-WN/a-Si₃N₄ und nc-TiN/a-WN, sowie nc-TiC/a-C:H. Als Aufbringtechniken kommen die chemische Gasphasenabscheidung (chemical vapor deposition CVD) und physikalische Gasfasenabscheidung (physical vapor deposition PVD) in Frage. Die Schichtdicken der Verschleißschutzbeschichtung beträgt dabei meist nicht mehr als 10 µm. Die mittlere Kristallitgröße der Nanokristalle beträgt zumeist unter 10 nm. Im Gegensatz zu herkömmlich eingelagerten Hartstoffpartikeln z.B. in amorphen Kohlenstoffschichten, besteht der Unterschied darin, dass die Partikel als nahezu fehlerfreie Nanokristalle dispergiert werden. Die Größe der Partikel liegt daher weit unter der Größe von bislang dispergierten Hartstoffpartikeln. Der Matrixanteil ist erfindungsgemäß sehr klein (wenige Prozent, unter 10 Volumen-Prozent)..

## Patentansprüche

1. Verschleißfeste Kette mit jeweils mittels eines Kettengelenks (4,23) miteinander verbundenen Kettengliedern (2,3;13,14), **dadurch gekennzeichnet, dass** zumindest ein einem Reibverschleiß ausgesetzter Oberflächenbereich (24,18,19) der Kettengelenke (4,23) und/oder des Kettengliedes (2,3;13,14) mit einer Verschleißschutzbeschichtung (25,26,27) mit zumindest zum Teil nanokristalliner Struktur versehen ist, dass Nanokristalle der Verschleißschutzbeschichtung (25,26,27) einen Durchmesser von ≤ 100 nm, bevorzugt ≤ 50 nm, aufweisen und dass die Verschleißschutzbeschichtung (25,26,27) eine amorphe Matrix umfasst, in der die Nanokristalle eingebettet sind und wobei der Matrixanteil ≤ 10 Vol.-% beträgt.

2. Kette nach einem der vorangegangenen Ansprüche, **dadurch gekennzeichnet, dass** Verschleißschutzbeschichtung (25,26,27) tetraedrisch gebundener amorpher Kohlenstoff, ta-C, umfasst.

3. Kette nach Anspruch 2, **dadurch gekennzeichnet, dass** die Verschleißschutzbeschichtung (25,26,27) eine Härte im Bereich von 4000 - 7500 HV aufweist.

4. Kette nach Anspruch 3 oder 4, **dadurch gekennzeichnet, dass** die Verschleißschutzbeschichtung (25,26,27) eine Schichtdicke von maximal 10 µm aufweist.

5. Kette nach einem der Ansprüche 1 bis 4, **dadurch gekennzeichnet, dass** die Verschleißschutzbeschichtung (25,26,27) eine Haftschicht mit Me-C:H oder CrN und eine Deckschicht mit DLC und Nanokristallen aus Si oder SiC oder DLC und Nanokristallen aus B und/oder BC umfasst.

6. Kette nach Anspruch 5, **dadurch gekennzeichnet, dass** die Verschleißschutzbeschichtung (25,26,27) eine Härte im Bereich von 1600 - 2100 HV aufweist.

7. Kette nach Anspruch 5 oder 6, **dadurch gekennzeichnet, dass** die Haftschicht maximal 1,5 µm und die Deckschicht maximal 1,5 µm dick ist.

8. Kette nach einem der Ansprüche 1 bis 3, **dadurch gekennzeichnet, dass** die Verschleißschutzbeschichtung (25,26,27) eine Matrix mit Si₃N₄ oder Bornitrid umfasst und die Nanokristalle TiN und/oder AIN enthalten.

9. Kette nach Anspruch 8, **dadurch gekennzeichnet, dass** die Verschleißschutzbeschichtung (25,26,27) eine Härte im Bereich von 40 - 45 GPa aufweist.

10. Kette nach Anspruch 8 oder 9, **dadurch gekennzeichnet, dass** die Verschleißschutzbeschichtung (25,26,27) eine Schichtdicke von 1 bis 4 µm aufweist.

11. Kette nach einem der Ansprüche 1 bis 3, **dadurch gekennzeichnet, dass** die Verschleißschutzbeschichtung (25,26,27) eine Matrix mit Si₃N₄ und Nanokristalle aus TiN und/oder SiN enthalten.

12. Kette nach Anspruch 11, **dadurch gekennzeichnet, dass** die Verschleißschutzbeschichtung eine Härte im Bereich von 30 - 45 GPa aufweist.

13. Ketten nach Anspruch 11 oder 12, **dadurch gekennzeichnet, dass** die Verschleißschutzbeschichtung (25,26,27) eine Schichtdicke von 2 - 4 µm aufweist.

14. Kette nach einem der Ansprüche 1 bis 3, **dadurch gekennzeichnet, dass** die Verschleißschutzbeschichtung (25,26,27) eine Metallmatrix umfasst.

15. Kette nach Anspruch 14, **dadurch gekennzeichnet, dass** die Metallmatrix Kupfer und/oder Wolfram und/oder Zink und/oder Zinn umfasst.

16. Kette nach Anspruch 14 oder 15, **dadurch gekennzeichnet, dass** die Nanokristalle Zirkonnitrid und/oder Al₂0₃ und/oder Si₃N₄ und/oder TiO₂ umfassen.

17. Kette nach einem der Ansprüche 1 bis 3, **dadurch gekennzeichnet, dass** die Verschleißschutzbeschichtung (25,26,27) BN und/oder B₄C und/oder VN umfasst.

18. Kette nach einem der Ansprüche 1 bis 3, **dadurch gekennzeichnet, dass** die Verschleißschutzbeschichtung (25,26,27) Nitridkeramikbildner und/oder Oxidkeramikbildner umfasst.

19. Kette nach einem der Ansprüche 1 bis 3, **dadurch gekennzeichnet, dass** die Verschleißschutzbeschichtung (25,26,27) mittels eines CVD-Verfahrens hergestellt ist.

20. Kette nach einem der Ansprüche 1 bis 3, **dadurch gekennzeichnet, dass** die Verschleißschutzbeschichtung mittels eines PVD-Verfahrens hergestellt ist.

21. Kette nach einem der vorangegangenen Ansprüche, **dadurch gekennzeichnet, dass** die Kettengelenke (4,23) ein Innen- und ein Außenelement umfassen und zumindest bereichsweise die Gelenkoberflächen des Innen- und/oder des Außenelementes mit einer Verschleißschutzbeschichtung versehen sind oder ist.

22. Kette nach einem der vorangegangenen Ansprüche, **dadurch gekennzeichnet, dass** die Kettenglieder (13,14) Zahnlaschen (15,21) umfassen und zumindest bereichsweise die in Eingriff mit einem Kettenrad kommenden Zahnflanken (18,19) mit einer Verschleißschutzbeschichtung (25,26,27) versehen sind.

23. Kette nach einem der vorangegangenen Ansprüche, **dadurch gekennzeichnet, dass** sich Außen- und Innenkettengleider (2,3) einander abwechseln und mittels jeweils eines Kettengelenks (4) miteinander verbunden sind, und die Außenkettenglieder (3) Außenlaschen (9) und Kettenbolzen (10) umfassen und die Innenkettenglieder (2) Innenlaschen (5), Gelenkhülsen (6) und Rollen (7) umfassen, wobei zumindest teilweise die in Wirkkontakt miteinander stehenden Oberflächenbereiche der Außenlaschen (9) und/oder der Kettenbolzen (10) und/oder der Innenlaschen (5) und/oder der Gelenkhülsen (6) und/oder der Rollen (7) mit einer Verschleißschutzbeschichtung versehen sind.

24. Kette nach einem der vorangegangenen Ansprüche, **dadurch gekennzeichnet, dass** das Kettengelenk (23) ein Wiegegelenk mit Wiegestiften (22.1,22.2) ist und zumindest die in Wirkkontakt stehenden Wiegeflächen der Wiegestifte (22.1,22.2) wenigstens bereichsweise mit einer Verschleißschutzbeschichtung versehen sind.

## Claims

1. Wear-resistant chain with chain links (2, 3; 13, 14) each connected to one another by means of a chain joint (4, 23), **characterized in that** at least one surface region (24, 18, 19) of the chain joints (4, 23) and/or of the chain link (2, 3; 13, 14) exposed to friction wear is provided with a wear-resistant coating (25, 26, 27) with at least partially nanocrystalline structure, that nanocrystals of the wear-resistant coating (25, 26, 27) have a diameter of ≤ 100 nm, preferably ≤ 50 nm, and that the wear-resistant coating (25, 26, 27) comprises an amorphous matrix in which the nanocrystals are embedded and wherein the matrix fraction is ≤ 10 vol.%.

2. Chain according to one of the preceding claims, **characterized in that** wear-resistant coating (25, 26, 27) comprises tetrahedrally bonded amorphous carbon ta-C.

3. Chain according to claim 2, **characterized in that** the wear-resistant coating (25, 26, 27) has a hardness in the range of 4000-7500 HV.

4. Chain according to claim 3 or 4, **characterized in that** the wear-resistant coating (25, 26, 27) has a layer thickness of not more than 10 µm.

5. Chain according to one of claims 1 to 4, **characterized in that** the wear-resistant coating (25, 26, 27) comprises an adhesive layer with Me-C:H or CrN and a top layer with DLC and nanocrystals of Si or SiC or DLC and nanocrystals of B and/or BC.

6. Chain according to claim 5, **characterized in that** the wear-resistant coating (25, 26, 27) has a hardness in the range 1600-2100 HV.

7. Chain according to claim 5 or 6, **characterized in that** the adhesive layer is not more than 1.5 µm and the top layer has a thickness of not more than 1.5 µm.

8. Chain according to one of claims 1 to 3, **characterized in that** the wear-resistant coating (25, 26, 27) comprises a matrix with Si₃N₄ or boron nitride and the nanocrystals contain TiN and/or AIN.

9. Chain according to claim 8, **characterized in that** the wear-resistant coating (25, 26, 27) has a hardness in the range of 40-45 GPa.

10. Chain according to claim 8 or 9, **characterized in that** the wear-resistant coating (25, 26, 27) has a layer thickness of 1 to 4 µm.

11. Chain according to one of claims 1 to 3, **characterized in that** the wear-resistant coating (25, 26, 27) contains a matrix with Si₃N₄ and nanocrystals of TiN and/or SiN.

12. Chain according to claim 11, **characterized in that** the wear-resistant coating has a hardness in the range of 30-45 GPa.

13. Chain according to claim 11 or 12, **characterized in that** the wear-resistant coating (25, 26, 27) has a layer thickness of 2-4 µm.

14. Chain according to one of claims 1 to 3, **characterized in that** the wear-resistant coating (25, 26, 27) comprises a metal matrix.

15. Chain according to claim 14, **characterized in that** the metal matrix comprises copper and/or tungsten and/or zinc and/or tin.

16. Chain according to claim 14 or 15, **characterized in that** the nanocrystals comprise zirconium nitride and/or Al₂O₃ and/or Si₃N₄ and/or TiO₂.

17. Chain according to one of claims 1 to 3, **characterized in that** the wear-resistant coating (25, 26, 27) comprises BN and/or B₄C and/or VN.

18. Chain according to one of claims 1 to 3, **characterized in that** the wear-resistant coating (25, 26, 27) comprises nitride ceramic formers and/or oxide ceramic formers.

19. Chain according to one of claims 1 to 3, **characterized in that** the wear-resistant coating (25, 26, 27) is produced by means of a CVD process.

20. Chain according to one of claims 1 to 3, **characterized in that** the wear-resistant coating is produced by means of a PVD process.

21. Chain according to one of the preceding claims, **characterized in that** the chain joints (4, 23) comprise an inner and an outer element and the joint surfaces of the inner and/or the outer element are or is provided at least in some regions with a wear-resistant coating.

22. Chain according to one of the preceding claims, **characterized in that** the chain links (13, 14) comprise tooth plates (15, 21) and the tooth flanks (18, 19) coming into engagement with a chain wheel are provided at least in some regions with a wear-resistant coating (25, 26, 27).

23. Chain according to one of the preceding claims, **characterized in that** outer and inner chain links (2, 3) alternate and are connected to one another by means of a respective chain joint (4), and the outer chain links (3) comprise outer plates (9) and chain pins (10) and the inner chain links (2) comprise inner plates (5), joint sleeves (6) and rollers (7), wherein the surface regions of the outer plates (9) and/or the chain pins (10) and/or the inner plates (5) and/or the joint sleeves (6) and/or the rollers (7) which are in effective contact with one another are provided at least partially with a wear-resistant coating.

24. Chain according to one of the preceding claims, **characterized in that** the chain joint (23) is a cradle joint with cradle pins (22.1, 22.2) and at least the cradle surfaces of the cradle pins (22.1, 22.2) which are in effective contact are provided at least in some regions with a wear-resistant coating.

## Revendications

1. Chaine anti-usure comprenant des maillons de chaine (2,3; 13, 14) respectivement reliés mutuellement au moyen d'une articulation de chaine (4, 23), **caractérisée en ce qu'**au moins une zone de surface (24, 18, 19) des articulations de chaine (4, 23) et/ou du maillon de chaine (2,3; 13, 14), exposée à une usure par friction, est pourvue d'un revêtement de protection contre l'usure (25, 26, 27) présentant au moins en partie une structure nanocristalline, **en ce que** des nanocristaux du revêtement de protection contre l'usure (25, 26, 27) présentent un diamètre ≤ 100 nm, de préférence ≤ 50 nm, et **en ce que** le revêtement de protection contre l'usure (25, 26, 27) comprend une matrice amorphe dans laquelle sont noyés les nanocristaux, et la part de matériau de matrice est ≤ 10% en volume.

2. Chaine selon l'une des revendications précédentes, **caractérisée en ce que** le revêtement de protection contre l'usure (25, 26, 27) comporte du carbone amorphe tétraédrique ta-C.

3. Chaine selon la revendication 2, **caractérisée en ce que** le revêtement de protection contre l'usure (25, 26, 27) présente une dureté dans une plage de 4000-7500 HV.

4. Chaine selon la revendication 2 ou la revendication 3, **caractérisée en ce que** le revêtement de protection contre l'usure (25, 26, 27) présente une épaisseur de couche d'au maximum 10 µm.

5. Chaine selon l'une des revendications 1 à 4, **caractérisée en ce que** le revêtement de protection contre l'usure (25, 26, 27) comprend une couche d'adhérence avec Me-C:H ou CrN, et une couche de recouvrement avec du DLC et des nanocristaux en Si ou SiC ou bien du DLC et des nanocristaux en B et/ou BC.

6. Chaine selon la revendication 5, **caractérisée en ce que** le revêtement de protection contre l'usure (25, 26, 27) présente une dureté dans une plage de 1600-2100 HV.

7. Chaine selon la revendication 5 ou la revendication 6, **caractérisée en ce que** la couche d'adhérence a une épaisseur maximale de 1,5 µm et la couche de recouvrement a une épaisseur maximale de 1,5 µm.

8. Chaine selon l'une des revendications 1 à 3, **caractérisée en ce que** le revêtement de protection contre l'usure (25, 26, 27) comprend une matrice avec Si₃N₄ ou du nitrure de bore, et les nanocristaux renferment TiN et/ou AlN.

9. Chaine selon la revendication 8, **caractérisée en ce que** le revêtement de protection contre l'usure (25, 26, 27) présente une dureté dans une plage de 40-45 GPa.

10. Chaine selon la revendication 8 ou la revendication 9, **caractérisée en ce que** le revêtement de protection contre l'usure (25, 26, 27) présente une épaisseur de couche de 1 à 4 µm.

11. Chaine selon l'une des revendications 1 à 3, **caractérisée en ce que** le revêtement de protection contre l'usure (25, 26, 27) renferme une matrice avec Si₃N₄, et des nanocristaux en TiN et/ou AlN.

12. Chaine selon la revendication 11, **caractérisée en ce que** le revêtement de protection contre l'usure présente une dureté dans une plage de 30-45 GPa.

13. Chaine selon la revendication 11 ou la revendication 12, **caractérisée en ce que** le revêtement de protection contre l'usure (25, 26, 27) présente une épaisseur de couche de 2-4 µm.

14. Chaine selon l'une des revendications 1 à 3, **caractérisée en ce que** le revêtement de protection contre l'usure (25, 26, 27) comprend une matrice métallique.

15. Chaine selon la revendication 14, **caractérisée en ce que** la matrice métallique comprend du cuivre et/ou du wolfram et/ou du zinc et/ou de l'étain.

16. Chaine selon la revendication 14 ou la revendication 15, **caractérisée en ce que** les nanocristaux comprennent du nitrure de zirconium et/ou Al₂O₃ et/ou Si₃N₄ et/ou TiO₂.

17. Chaine selon l'une des revendications 1 à 3, **caractérisée en ce que** le revêtement de protection contre l'usure (25, 26, 27) comprend BN et/ou B₄C et/ou VN.

18. Chaine selon l'une des revendications 1 à 3, **caractérisée en ce que** le revêtement de protection contre l'usure (25, 26, 27) comprend des générateurs de nitrure de céramique et/ou des générateurs d'oxydes de céramique.

19. Chaine selon l'une des revendications 1 à 3, **caractérisée en ce que** le revêtement de protection contre l'usure (25, 26, 27) est fabriqué par un procédé CVD (dépôt chimique en phase vapeur).

20. Chaine selon l'une des revendications 1 à 3, **caractérisée en ce que** le revêtement de protection contre l'usure est fabriqué par un procédé PVD (dépôt physique en phase vapeur).

21. Chaine selon l'une des revendications précédentes, **caractérisée en ce que** les articulations de chaine (4, 23) comprennent un élément intérieur et un élément extérieur, et les surfaces d'articulation de l'élément intérieur et/ou de l'élément extérieur sont pourvues au moins par secteurs, d'un revêtement de protection contre l'usure.

22. Chaine selon l'une des revendications précédentes, **caractérisée en ce que** les maillons de chaine (13, 14) comportent des éclisses dentées (15, 21), et les flancs de dent (18, 19) venant en prise avec une roue à chaine sont pourvus au moins par secteurs, d'un revêtement de protection contre l'usure (25, 26, 27) .

23. Chaine selon l'une des revendications précédentes, **caractérisée en ce que** des maillons de chaine extérieurs et des maillons de chaine intérieurs (2, 3) alternent mutuellement et sont reliés respectivement au moyen d'une articulation de chaine (4), et les maillons de chaine extérieurs (3) comportent des éclisses extérieures (9) et des axes de chaine (10), et les maillons de chaine intérieurs (2) des éclisses intérieures (5), des douilles d'articulation (6) et des galets (7), les secteurs de surface des éclisses extérieures (9) et/ou des axes de chaine (10) et/ou des éclisses intérieures (5) et/ou des douilles d'articulation (6) et/ou des galets (7) mutuellement en contact d'interaction réciproque étant pourvues, au moins en partie, d'un revêtement de protection contre l'usure.

24. Chaine selon l'une des revendications précédentes, **caractérisée en ce que** l'articulation de chaine (23) est une articulation à basculement avec des broches de basculement (22.1, 22.2) et au moins les surfaces de basculement des broches de basculement (22.1, 22.2) en contact d'interaction réciproque, sont pourvues au moins par secteurs, d'un revêtement de protection contre l'usure.
